# EUROPEAN PATENT APPLICATION

(11) **EP 4 654 260 A1**
(43) Date of publication of application: **26.11.2025**
(21) Application number: 25174179.9
(22) Date of filing: 05.05.2025
(51) Int. Cl.: H01L 23/498

(54) **SEMICONDUCTOR DEVICE**

(30) Priority: 23.05.2024 JP 2024084118
(71) Applicant: Shinko Electric Industries Co., Ltd., Nagano-shi, Nagano-ken 381-2287 (JP)
(72) Inventor: KOI, Kenichi, Nagano-shi 381-2287 (JP)
(74) Representative: Groth & Co. KB

(57) **Abstract**

A semiconductor device (10) includes a lower substrate (20), a semiconductor element (30) mounted on an upper surface of the lower substrate (20), and an upper substrate (40) arranged on an upper surface of the semiconductor element (30). The semiconductor element (30) includes an electrode (32) arranged on the upper surface of the semiconductor element (30). The semiconductor device (10) includes via wirings (80) and a wiring layer (60). The via wirings (80) extend through the upper substrate (40) in a thickness-wise direction and are connected to the electrode (32). The wiring layer (60) is arranged on an upper surface of the upper substrate (40) and is electrically connected to the electrode (32) by the via wirings (80). The via wirings (80) include two or more types of via wirings (80:81,82,83) that differ from one another in planar size. The via wirings (80) are arranged so that the planar size decreases from a peripheral portion of the semiconductor element (30) toward a central portion of the semiconductor element (30) in plan view.

## Description

### BACKGROUND

### 1. Field

This disclosure relates to a semiconductor device.

### 2. Description of Related Art

A power semiconductor device (power module) controls and supplies electric power. This type of semiconductor device typically includes a semiconductor element arranged between a lower substrate and an upper substrate, an encapsulation resin disposed between the lower substrate and the upper substrate and encapsulating the semiconductor element, and a wiring layer formed on an upper surface of the upper substrate. The wiring layer formed on the upper surface of the upper substrate is electrically connected to, for example, an electrode of the semiconductor element by multiple via wirings that extend through the upper substrate in a thickness-wise direction. Japanese Laid-Open Patent Publication No. 2018-120902 discloses such a typical example.

### SUMMARY

This Summary is provided to introduce a selection of concepts in a simplified form that are further described below in the Detailed Description. This Summary is not intended to identify key features or essential features of the claimed subject matter, nor is it intended to be used as an aid in determining the scope of the claimed subject matter.

In the semiconductor device described above, it is desired to minimize decreases in the reliability of electrical connection between the wiring layer, which is formed on the upper surface of the upper substrate, and the electrode of the semiconductor element.

In one embodiment, a semiconductor device includes a lower substrate, a semiconductor element, an upper substrate, via wirings, and a wiring layer. The semiconductor element is mounted on an upper surface of the lower substrate. The semiconductor element includes a first electrode arranged on an upper surface of the semiconductor element. The upper substrate is arranged on the upper surface of the semiconductor element. The via wirings extend through the upper substrate in a thickness-wise direction and are connected to the first electrode. The wiring layer is arranged an upper surface of the upper substrate and is electrically connected to the first electrode by the via wirings. The via wirings include two or more types of via wirings differing from one another in planar size. The via wirings are arranged so that the planar size decreases from a peripheral portion of the semiconductor element toward a central portion of the semiconductor element in plan view.

Other features and aspects will be apparent from the following detailed description, the drawings, and the claims.

### BRIEF DESCRIPTION OF THE DRAWINGS

Fig. 1 is a schematic plan view of a semiconductor device in accordance with an embodiment.
Fig. 2 is a schematic plan view enlarging part of the semiconductor device illustrated in Fig. 1.
Fig. 3 is a schematic cross-sectional view of the semiconductor device taken along line 3-3 illustrated in Fig. 1.
Figs. 4, 5, 6, and 7 are schematic plan views illustrating various modified examples of the semiconductor device.

Throughout the drawings and the detailed description, the same reference numerals refer to the same elements. The drawings may not be to scale, and the relative size, proportions, and depiction of elements in the drawings may be exaggerated for clarity, illustration, and convenience.

### DETAILED DESCRIPTION

This description provides a comprehensive understanding of the methods, apparatuses, and/or systems described. Modifications and equivalents of the methods, apparatuses, and/or systems described are apparent to one of ordinary skill in the art. Sequences of operations are exemplary, and may be changed as apparent to one of ordinary skill in the art, with the exception of operations necessarily occurring in a certain order. Descriptions of functions and constructions that are well known to one of ordinary skill in the art may be omitted.

Exemplary embodiments may have different forms, and are not limited to the examples described. However, the examples described are thorough and complete, and convey the full scope of the disclosure to one of ordinary skill in the art.

In this specification, "at least one of A and B" should be understood to mean "only A, only B, or both A and B."

An embodiment will now be described with reference to the drawings.

The accompanying drawings may not be drawn to scale, and the relative size, proportions, and depiction of elements may be exaggerated for clarity, illustration, or convenience. In the cross-sectional views, hatching lines may not be illustrated or may be replaced by shadings to facilitate understanding of the cross-sectional structures. Each drawing indicates an X-axis, a Y-axis, and a Z-axis that are orthogonal to one another. In the description hereafter, to facilitate understanding, a direction extending along the X-axis will be referred to as the X-axis direction, a direction extending along the Y-axis will be referred to as the Y-axis direction, and a direction extending along the Z-axis will be referred to as the Z-axis direction. In this specification, the term "plan view" refers to a view of a subject taken in the Z-axis direction, and the term "planar shape" refers to a shape of a subject as viewed in the Z-axis direction. Unless otherwise specified, a numerical range of "X1 to X2", which is specified by a lower limit value X1 and an upper limit value X2, refers to a range that is greater than or equal to X1 and less than or equal to X2.

### Overall Structure of Semiconductor Device 10

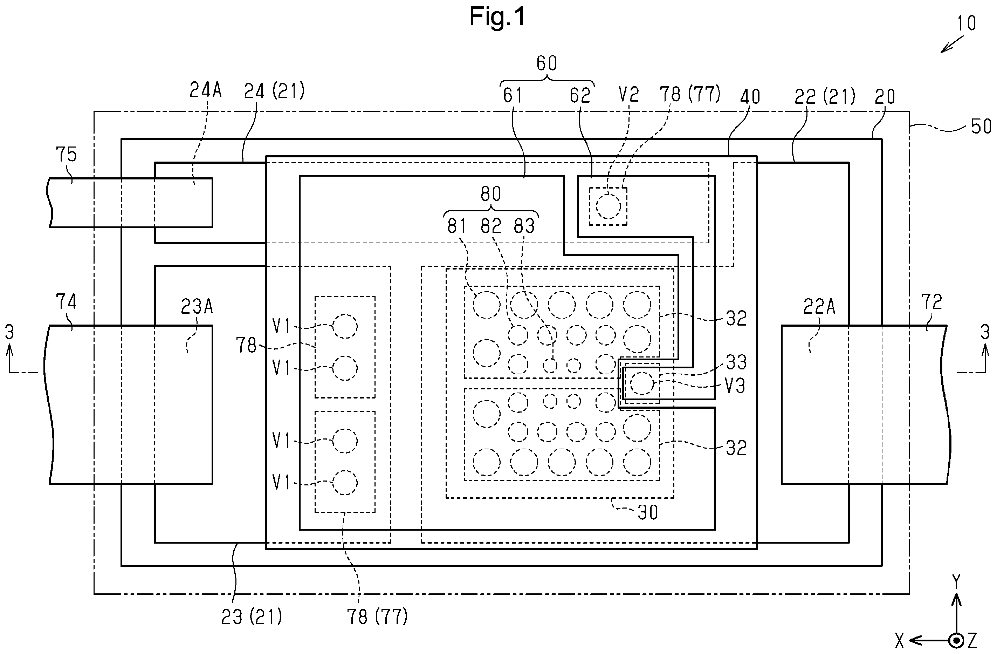

The overall structure of a semiconductor device 10 will now be described with reference to Figs. 1 to 3.

The semiconductor device 10 illustrated in Figs. 1 to 3 is, for example, a power semiconductor device (power module) that controls and supplies electric power. The semiconductor device 10 may be, for example, a DC-DC converter.

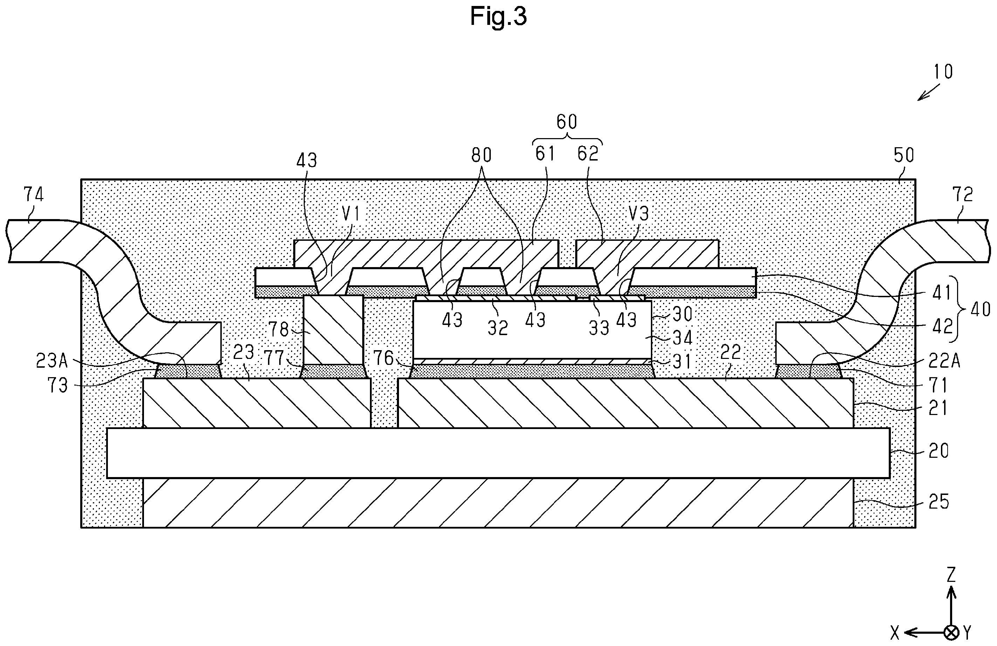

As illustrated in Fig. 3, the semiconductor device 10 includes a lower substrate 20, at least one (in the present embodiment, one) semiconductor element 30 mounted on an upper surface of the lower substrate 20, and an upper substrate 40 arranged on an upper surface of the semiconductor element 30. The lower substrate 20 includes a wiring layer 21 arranged on the upper surface of the lower substrate 20, and a metal layer 25 arranged on a lower surface of the lower substrate 20. The semiconductor device 10 includes an encapsulation resin 50 and a wiring layer 60. The encapsulation resin 50 is arranged between the lower substrate 20 and the upper substrate 40 and encapsulates the semiconductor element 30. The wiring layer 60 is electrically connected to the semiconductor element 30 and arranged on an upper surface of the upper substrate 40. The semiconductor element 30 is disposed between the upper surface of the lower substrate 20 and a lower surface of the upper substrate 40. The semiconductor device 10 incorporates the semiconductor element 30 between the lower substrate 20 and the upper substrate 40.

### Structure of Semiconductor Element 30

The semiconductor element 30 is formed from, for example, silicon (Si) or silicon carbide (SiC). The semiconductor element 30 is, for example, a power semiconductor element. The semiconductor element 30 may be, for example, an insulated gate bipolar transistor (IGBT), a metal-oxide-semiconductor field-effect transistor (MOSFET), a diode, or the like. In the example illustrated in Fig. 3, the semiconductor element 30 is a MOSFET. The semiconductor element 30 may have any planar shape and any size. The semiconductor element 30 has, for example, a rectangular planar shape. The planar size of the semiconductor element 30 may be, for example, approximately 5 mm × 5 mm. The thickness of the semiconductor element 30 may be, for example, in a range of 50 µm to 775 µm.

The semiconductor element 30 includes, for example, an electrode 31 arranged at a side of the lower surface of the semiconductor element 30, and electrodes 32 and 33 arranged at a side of the upper surface of the semiconductor element 30. The semiconductor element 30 includes, for example, a body portion 34. The electrodes 32 and 33 are located at a side of the semiconductor element 30 opposite to the electrode 31. The electrode 31 is, for example, a drain electrode of the MOSFET. The electrode 32 is, for example, a source electrode of the MOSFET. The electrode 33 is, for example, a gate electrode of the MOSFET.

The material of the electrodes 31, 32, and 33 may be, for example, a metal, such as aluminum (Al), copper (Cu), or the like, or an alloy including at least one of Al and Cu. A surface-processed layer may be formed on surfaces of the electrodes 31, 32, and 33. Examples of the surface-processed layer may include a gold (Au) layer, a nickel (Ni) layer/Au layer (metal layer in which the Ni layer serves as bottom layer, and the Au layer is formed on the Ni layer), a Ni layer/palladium (Pd) layer/Au layer (metal layer in which the Ni layer serves as bottom layer, and the Pd layer and the Au layer are sequentially formed on the Ni layer), or the like. The Au layer, the Ni layer, and the Pd layer may each be, for example, a metal layer formed by an electroless plating process, that is, an electroless plating layer. The Au layer is a metal layer formed from Au or an Au alloy, a Ni layer is a metal layer formed from Ni or a Ni alloy, and a Pd layer is a metal layer formed from Pd or a Pd alloy.

The electrode 31 is, for example, located on a lower surface of the body portion 34. The electrode 31 covers, for example, the entire lower surface of the body portion 34.

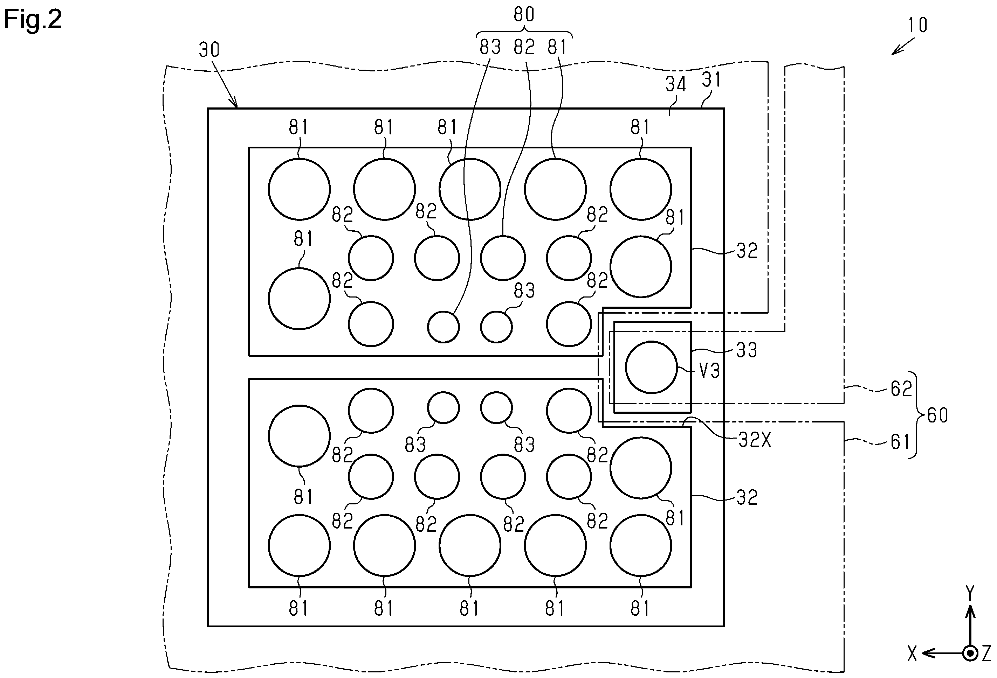

As illustrated in Fig. 2, for example, the electrodes 32 and 33 are located on an upper surface of the body portion 34. For example, two electrodes 32 and one electrode 33 are disposed on the upper surface of the body portion 34. The two electrodes 32 are separated from each other on the upper surface of the body portion 34. The two electrodes 32 are, for example, arranged next to each other in the Y-axis direction. Each of the electrodes 32 includes a recess 32X, for example, in a right side portion of Fig. 2. The electrode 33 is, for example, separated from the electrodes 32 on the upper surface of the body portion 34. In plan view, for example, the electrode 33 is embedded in the two recesses 32X.

### Structure of Lower Substrate 20

As illustrated in Fig. 1, the lower substrate 20 is plate-shaped. The lower substrate 20 is, for example, a ceramic substrate formed from ceramic, such as an oxide-based ceramic, a non-oxide-based ceramic, or the like. Examples of an oxide-based ceramic include aluminum oxide (Al₂O₃), zirconia (ZrO₂), or the like. Examples of a non-oxide-based ceramic include aluminum nitride (AIN), silicon nitride (Si₃N₄), or the like.

The lower substrate 20 may have any planar shape and any size. The lower substrate 20 has, for example, a rectangular planar shape. The thickness of the lower substrate 20 may be, for example, in a range of 200 µm to 400 µm. Fig. 1 is a plan view of the semiconductor device 10 illustrated in Fig. 3 as viewed from above. In Fig. 1, the semiconductor device 10 is illustrated as seen through the encapsulation resin 50. Fig. 2 is a plan view enlarging part of the semiconductor device 10 illustrated in Fig. 1. In Fig. 2, the part of the semiconductor device 10 is illustrated as seen through the upper substrate 40, the encapsulation resin 50, and the wiring layer 60.

### Structure of Metal Layer 25

As illustrated in Fig. 3, the metal layer 25 is arranged on the lower surface of the lower substrate 20. The metal layer 25 may have any planar shape and any size. The metal layer 25 has, for example, a rectangular planar shape. The metal layer 25 is, for example, formed as a solid plane. The metal layer 25 is, for example, arranged across the entire lower surface of the lower substrate 20 except for peripheral edges of the lower surface of the lower substrate 20. The metal layer 25 acts as, for example, a reinforcement layer that restrains warping or the like of the lower substrate 20. The metal layer 25 may also act as, for example, a heat dissipator.

The material of the metal layer 25 may be, for example, copper or a copper alloy. A surface-processed layer may be formed on a surface (lower and side surfaces or lower surface only) of the metal layer 25. The surface-processed layer may be a metal layer, such as an Au layer, a Ni layer/Au layer, or a Ni layer/Pd layer/Au layer, or the like. The thickness of the metal layer 25 may be, for example, in a range of 100 µm to 800 µm.

### Structure of Wiring Layer 21

As illustrated in Fig. 1, for example, the wiring layer 21 includes a number of wiring patterns. In the example illustrated in Fig. 1, the wiring layer 21 includes wiring patterns 22, 23, and 24.

The material of the wiring patterns 22, 23, and 24 may be, for example, copper or a copper alloy. A surface-processed layer may be formed on surfaces (upper and side surfaces or upper surface only) of the wiring patterns 22, 23, and 24. The surface-processed layer may be a metal layer, such as an Au layer, a Ni layer/Au layer, or a Ni layer/Pd layer/Au layer, or the like. The thickness of the wiring patterns 22, 23, and 24 may each be, for example, in a range of 100 µm to 800 µm.

The wiring patterns 22, 23, and 24 are separated from one another on the upper surface of the lower substrate 20. The wiring patterns 22, 23, and 24 may each have any planar shape and any size.

The planar shape of the wiring pattern 22 is, for example, L-shaped as a whole. The wiring pattern 22 includes, for example, a belt-shaped first part having a given width in the Y-axis direction, which is a planar direction, and extending in the X-axis direction, which is another planar direction. The wiring pattern 22 includes, for example, a second part extending from the first part in the Y-axis direction. For example, part of the wiring pattern 22 overlaps the upper substrate 40 in plan view, and the remaining part of the wiring pattern 22 is exposed from the upper substrate 40. The wiring pattern 22 overlaps, for example, the semiconductor element 30 in plan view. As illustrated in Fig. 3, for example, the wiring pattern 22 is electrically connected to the electrode 31 of the semiconductor element 30. That is, the wiring pattern 22 is electrically connected to the electrode 31 that serves as the drain electrode.

The wiring pattern 22 includes, for example, a current input terminal 22A. For example, the current input terminal 22A is defined by part of an upper surface of the wiring pattern 22 that does not overlap the upper substrate 40 in plan view. The current input terminal 22A is, for example, bonded to a first end of a connection terminal 72 by a conductive joint 71. The current input terminal 22A is, for example, electrically connected to an external electrode disposed outside the semiconductor device 10 through the joint 71 and the connection terminal 72. For example, current is input to the current input terminal 22A from a circuit, a power supply, or the like disposed outside the semiconductor device 10. The current input terminal 22A of the present embodiment is a drain electrode terminal. The first end of the connection terminal 72 is embedded in the encapsulation resin 50. The connection terminal 72 has a second end located opposite to the first end and extending out of the encapsulation resin 50.

As illustrated in Fig. 1, for example, the wiring pattern 23 has a rectangular planar shape. The wiring pattern 23 is, for example, belt-shaped having a given width in the Y-axis direction and extending in the X-axis direction. The wiring pattern 23 faces, for example, the wiring pattern 22 in the X-axis direction. For example, part of the wiring pattern 23 overlaps the upper substrate 40 in plan view, and the remaining part of the wiring pattern 23 is exposed from the upper substrate 40. The wiring pattern 23 is, for example, electrically connected to the electrodes 32 of the semiconductor element 30. That is, the wiring pattern 23 is electrically connected to the electrodes 32 that serve as the source electrodes.

As illustrated in Fig. 3, for example, the wiring pattern 23 includes a current output terminal 23A. For example, the current output terminal 23A is defined by part of an upper surface of the wiring pattern 23 that does not overlap the upper substrate 40 in plan view. The current output terminal 23A is, for example, bonded to a first end of a connection terminal 74 by a conductive joint 73. The current output terminal 23A is, for example, electrically connected to an external electrode disposed outside the semiconductor device 10 through the joint 73 and the connection terminal 74. For example, the current output terminal 23A outputs current to a circuit or the like disposed outside the semiconductor device 10. The current output terminal 23A of the present embodiment is a source electrode terminal. The first end of the connection terminal 74 is embedded in the encapsulation resin 50. The connection terminal 74 has a second end located opposite to the first end and extending out of the encapsulation resin 50.

As illustrated in Fig. 1, for example, the wiring pattern 24 has a rectangular planar shape. The wiring pattern 24 is, for example, belt-shaped having a given width in the Y-axis direction and extending in the X-axis direction. The wiring pattern 24 is arranged, for example, in a portion of Fig. 1 located above the wiring pattern 23. The wiring pattern 24 extends, for example, parallel to the wiring pattern 23. The wiring pattern 24 has, for example, a greater length than the wiring pattern 23 in the X-axis direction. For example, part of the wiring pattern 24 overlaps the upper substrate 40 in plan view, and the remaining part of the wiring pattern 24 is exposed from the upper substrate 40. The wiring pattern 24 is, for example, electrically connected to the electrodes 33 of the semiconductor element 30. That is, the wiring pattern 24 is electrically connected to the electrode 33 that serves as the gate electrode.

The wiring pattern 24 includes, for example, a connection terminal 24A. The connection terminal 24A is defined by part of an upper surface of the wiring pattern 24 that does not overlap the upper substrate 40 in plan view. The connection terminal 24A is, for example, bonded to a first end of a connection terminal 75 by a conductive joint (not illustrated). The connection terminal 24A is, for example, electrically connected to an external electrode disposed outside the semiconductor device 10 through the connection terminal 75 and the like. The connection terminal 24A is, for example, a gate electrode terminal.

### Structure of Joint 76

As illustrated in Fig. 3, the semiconductor element 30 is bonded to the upper surface of the wiring pattern 22 by a conductive joint 76. The joint 76 is bonded to the wiring pattern 22 and the electrode 31. The joint 76 electrically connects the wiring pattern 22 and the electrode 31 of the semiconductor element 30.

As illustrated in Fig. 1, for example, the entire semiconductor element 30 overlaps the wiring pattern 22 in plan view. The entire semiconductor element 30 overlaps, for example, the upper substrate 40 in plan view.

### Structure of Joint 77

As illustrated in Fig. 3, a conductive joint 77 is arranged on the upper surface of the wiring pattern 23. Although not illustrated in detail, a joint 77 is also arranged on an upper surface of the wiring pattern 24 illustrated in Fig. 1. A connection member 78 is formed on an upper surface of each joint 77. The joint 77 is bonded to the connection member 78, and the wiring pattern 23 or the wiring pattern 24 (refer to Fig. 1). As illustrated in Fig. 3, the joint 77 electrically connects the wiring pattern 23 and the connection member 78. As illustrated in Fig. 1, the joint 77 electrically connects the wiring pattern 24 and the connection member 78.

The material of the joints 71, 73, 76, and 77 illustrated in Fig. 3 may be, for example, a metal sintering material. The sintering material may be, for example, a sintering material including silver (Ag) particles as a main component (silver sintering material) or a sintering material including copper particles as a main component (copper sintering material). Alternatively, the material of the joints 71, 73, 76, and 77 may be, for example, solder, a conductive paste such as a silver paste, or a brazing metal. The thickness of the joints 71, 73, 76, and 77 may each be, for example, in a range of 10 µm to 60 µm.

### Structure of Connection Member 78

The connection members 78 are electrically connected to the wiring layer 60 arranged on the upper surface of the upper substrate 40. Hence, the wiring patterns 23 and 24 are electrically connected to the wiring layer 60 through the joints 77 and the connection members 78. For example, the connection members 78 are rod-shaped and extend in a stacking direction of the semiconductor device 10 (here, z-axis direction). The connection members 78 are, for example, metal posts. The connection members 78 have, for example, the same thickness as the semiconductor element 30. The thickness of the connection members 78 may each be, for example, in a range from 50 µm to 775 µm. The material of the connection members 78 may be, for example, copper or a copper alloy.

### Structure of Upper Substrate 40

As illustrated in Fig. 3, the upper substrate 40 is arranged on the upper surface of the semiconductor element 30 where the electrodes 32 and 33 are located. That is, the upper substrate 40 is located above the semiconductor element 30. The upper substrate 40 is arranged on the upper surface of the semiconductor element 30 and on upper surfaces of the connection members 78. The upper substrate 40 is plate-shaped. The upper substrate 40 may have any planar shape and any size. As illustrated in Fig. 1, for example, the upper substrate 40 has a rectangular planar shape. The upper substrate 40 has, for example, a smaller planar shape than the lower substrate 20. The upper substrate 40 has, for example, a smaller dimension than the lower substrate 20 in the X-axis direction. The upper substrate 40 has, for example, a smaller dimension than the lower substrate 20 in the Y-axis direction. For example, the entire upper substrate 40 overlaps the lower substrate 20 in plan view.

As illustrated in Fig. 3, for example, the upper substrate 40 includes a substrate body 41, and an adhesive layer 42 disposed on a lower surface of the substrate body 41. The material of the substrate body 41 may be, for example, an insulating resin, such as a polyimide-based resin, a polyimide-based resin, or the like. The adhesive layer 42 may be, for example, an epoxy-based, polyimide-based, or silicone-based adhesive. The thickness of the substrate body 41 may be, for example, in a range from 30 µm to 50 µm. The thickness of the adhesive layer 42 may be, for example, in a range from 15 µm to 45 µm.

The substrate body 41 is, for example, adhered to the semiconductor element 30 and the connection members 78 by the adhesive layer 42. The adhesive layer 42 is adhered to the upper surface of the semiconductor element 30 and the lower surface of the substrate body 41. The adhesive layer 42 is adhered to the upper surfaces of the connection members 78 and the lower surface of the substrate body 41. The adhesive layer 42 incorporates, for example, part of the semiconductor element 30. In other words, part of the semiconductor element 30 is embedded in the adhesive layer 42. For example, the electrodes 32 and 33 of the semiconductor element 30 are partially embedded in the adhesive layer 42. The adhesive layer 42 incorporates, for example, upper parts of the connection members 78. In other words, the upper parts of the connection members 78 are embedded in the adhesive layer 42.

The upper substrate 40 includes multiple openings 43 that extend through the upper substrate 40 in the thickness-wise direction (in the present embodiment, z-axis direction). Each of the openings 43 extends through, for example, the substrate body 41 and the adhesive layer 42 in the thickness-wise direction. The opening 43 is, for example, tapered so that the opening width (diameter) is decreased from the upper side (the upper surface of the upper substrate 40) toward the lower side (the lower surface of the upper substrate 40) in Fig. 3. The opening 43 has, for example, a shape of an inverted truncated cone so that the opening diameter of its lower end is smaller than the opening diameter of its upper end. Some of the openings 43 expose, for example, part of upper surfaces of the electrodes 32 and 33. Some of the openings 43 expose, for example, part of the upper surfaces of the connection members 78.

### Structure of Wiring Layer 60

The wiring layer 60 is located on the upper surface of the upper substrate 40. The wiring layer 60 includes, for example, wiring patterns 61 and 62. The material of the wiring patterns 61 and 62 may be, for example, copper or a copper alloy. A surface-processed layer may be formed on surfaces (upper and side surfaces or upper surface only) of the wiring patterns 61 and 62. The surface-processed layer may be a metal layer, such as an Au layer, a Ni layer/Au layer, or a Ni layer/Pd layer/Au layer, or the like. The thickness of the wiring patterns 61 and 62 may each be, for example, in a range from 50 µm to 200 µm.

The wiring patterns 61 and 62 are separated from each other on the upper surface of the upper substrate 40. The wiring patterns 61 and 62 may have any planar shape and any size.

### Structure of Wiring Pattern 61

The wiring pattern 61 electrically connects, for example, the wiring pattern 23 and the electrodes 32 of the semiconductor element 30. The wiring pattern 61 electrically connects, for example, the current output terminal 23A of the wiring pattern 23 and the electrodes 32 of the semiconductor element 30. As illustrated in Fig. 1, for example, the wiring pattern 61 extends from the electrodes 32 toward the current output terminal 23A in the X-axis direction.

In an example, part of the wiring pattern 61 overlaps the wiring pattern 23 in plan view. The wiring pattern 61 overlaps, for example, a right side portion of the wiring pattern 23 illustrated in Fig. 1 in plan view. As illustrated in Fig. 3, for example, the wiring pattern 61 is electrically connected to the connection members 78 arranged on the wiring pattern 23 by one or more via wirings V1 that extend through the upper substrate 40 in the thickness-wise direction. The wiring pattern 61 is, for example, electrically connected to the wiring pattern 23 through the via wirings V1, the connection members 78, and the joints 77. The wiring pattern 61 is, for example, formed integrally with the via wirings V1. The via wirings V1 are, for example, formed in the openings 43 that expose parts of the upper surfaces of the connection members 78. The openings 43 are, for example, filled with the via wirings V1.

As illustrated in Fig. 1, for example, part of the wiring pattern 61 overlaps the semiconductor element 30 in plan view. The wiring pattern 61 overlaps, for example, the electrodes 32 of the semiconductor element 30 in plan view. The wiring pattern 61 overlaps, for example, two electrodes 32 in plan view. As illustrated in Fig. 3, for example, the wiring pattern 61 is electrically connected to the electrodes 32 by one or more via wirings 80 that extend through the upper substrate 40 in the thickness-wise direction. Therefore, the wiring pattern 61 is electrically connected to the electrodes 32 through the via wirings 80, and is electrically connected to the wiring pattern 23 through the via wirings V1, the connection members 78, and the joints 77. In other words, the wiring pattern 23 including the current output terminal 23A is electrically connected to the electrodes 32, which are source electrodes, through the joints 77, the connection members 78, the via wirings V1, the wiring pattern 61, and the via wirings 80. The wiring pattern 61 is, for example, formed integrally with the via wirings 80. In Fig. 3, the number of via wirings 80 is reduced to simplify illustration.

### Structure of Via Wiring 80

The via wirings 80 extend through the upper substrate 40 in the thickness-wise direction and are connected to the electrodes 32. The via wirings 80 are, for example, formed in the openings 43 that expose parts of the upper surfaces of the electrodes 32. The openings 43 are, for example, filled with the via wirings 80. As illustrated in Fig. 2, for example, multiple (in the present embodiment, thirty) via wirings 80 are arranged for the two electrodes 32. In the example illustrated in Fig. 2, fifteen via wirings 80 are arranged for each of the two electrodes 32. The thirty via wirings 80 are, for example, arranged next to one another in the X-axis direction and the Y-axis direction.

The via wirings 80 include two or more (in the present embodiment, three) types of via wirings 81, 82, and 83 having different planar sizes. The via wirings 81, 82, and 83 may have any planar shape. The via wirings 81, 82, and 83 may have the same planar shape or different planar shapes. In the example illustrated in Fig. 2, the via wirings 81, 82, and 83 have the same circular planar shape. The via wiring 81 has a greater planar size than each of the via wirings 82 and 83. That is, the via wiring 81 has a greater via diameter (diameter) than each of the via wirings 82 and 83. The via wiring 82 has a greater planar size than the via wiring 83. That is, the via wiring 82 has a greater via diameter than the via wiring 83. Thus, the via wiring 81 is a type of the via wiring 80 having the largest planar size among the via wirings 81, 82, and 83. The via wiring 82 is a type of the via wiring 80 having the second largest planar size among the via wirings 81, 82, and 83. The via wiring 83 is a type of the via wiring 80 having the smallest planar size among the via wirings 81, 82, and 83. The via diameter of the via wiring 81 may be, for example, in a range of 450 µm to 550 µm. The via diameter of the via wiring 82 may be, for example, in a range of 350 µm to 450 µm. The via diameter of the via wiring 83 may be, for example, in a range of 250 µm to 350 µm.

In the present embodiment, the thirty via wirings 80 include fourteen via wirings 81, twelve via wirings 82, and four via wirings 83. In the present embodiment, each of the two electrodes 32 is connected to seven via wirings 81, six via wirings 82, and two via wirings 81.

The present inventor has conducted extensive studies and found that the reliability of electrical connection with the electrode 32 is more likely to decrease in the via wiring 80 arranged in a peripheral portion of the semiconductor element 30 than in the via wiring 80 arranged in a central portion of the planar surface of the semiconductor element 30. For example, when a temperature cycling test, which is a type of reliability test, was performed on the semiconductor device 10, the bonded area between the via wiring 80 and the electrode 32 became smaller as the number of temperature cycles of the test increased. In this case, it was found that, as the via wiring 80 becomes closer to the peripheral edges (outer peripheral edges) of the semiconductor element 30, the bonded area between the via wiring 80 and the electrode 32 is more likely to become smaller and the reliability of electrical connection between the via wiring 80 and the electrode 32 is more likely to decrease. In other words, when a temperature cycling test was performed on the semiconductor device 10, the joined area between the via wiring 80 and the electrode 32 started to diminish from the peripheral portion of the semiconductor element 30. This may be because an amount of deformation resulting from stress or the like produced during the temperature cycling test was greater in the peripheral portion of the semiconductor element 30 than in the central portion of the semiconductor element 30. In addition, it was found that when the temperature cycling test was performed on the semiconductor device 10, as the via diameter of the via wiring 80 becomes smaller, the bonded area between the via wiring 80 and the electrode 32 is more likely to become smaller and the reliability of electrical connection between the via wiring 80 and the electrode 32 is more likely to decrease.

Accordingly, in the semiconductor device 10, multiple types of via wirings 81, 82, and 83 are arranged so that the planar size decreases from the peripheral portion toward the central portion of the semiconductor element 30 in plan view. In the example illustrated in Fig. 2, the via wirings 81, 82, and 83 are arranged so that the planar size decreases from the peripheral portion toward the central portion of the semiconductor element 30 in both the X-axis direction and the Y-axis direction. In other words, the via wirings 81, 82, and 83 are arranged so that the planar size is smallest in the central portion of the semiconductor element 30 and increases toward the peripheral portion of the semiconductor element 30 in concentric circular shapes in plan view.

As illustrated in Fig. 2, the via wirings 83 having the smallest planar size are located in the central portion of the semiconductor element 30 in plan view. In an example, four via wirings 83 are arranged in a matrix pattern in a central region of the semiconductor element 30 in plan view. Each of the four via wirings 83 is disposed in the central region of the semiconductor element 30 that overlaps the electrode 32 in plan view. Each of the two electrodes 32 is provided with two of the four via wirings 83. The two via wirings 83 provided for the electrode 32 are arranged next to each other in the X-axis direction.

The via wirings 82 having the second largest planar size are located closer to the peripheral edges of the semiconductor element 30 than the via wirings 83 are. In an example, twelve via wirings 82 surround the four via wirings 83 in plan view. Each of the twelve via wirings 82 is disposed in a region overlapping the electrodes 32 and located closer to the peripheral edges than the via wirings 83 are. Each of the two electrodes 32 is provided with six of the twelve via wirings 82.

The via wirings 81 having the largest planar size are located closer to the peripheral edges of the semiconductor element 30 than the via wirings 82 are. In an example, fourteen via wirings 81 surround the twelve via wirings 82 in plan view. The fourteen via wirings 81 are disposed in a peripheral region of the semiconductor element 30. That is, the fourteen via wirings 81 are arranged along the peripheral edges of the semiconductor element 30. Each of the fourteen via wirings 81 is disposed in a region overlapping the electrodes 32 and located closer to the peripheral edges than the via wirings 82 are. Each of the two electrodes 32 is provided with seven of the fourteen via wirings 81.

Two adjacent ones of the via wirings 80 are, for example, spaced apart from each other by at least a distance L1 (not illustrated) regardless of the planar size of the two via wirings 80. Therefore, the distance between two adjacent ones of the via wirings 81 is at least the distance L1, and the distance between two adjacent ones of the via wirings 81 and 82 is at least the distance L1. Furthermore, the distance between two adjacent ones of the via wirings 82 is at least the distance L1, the distance between two adjacent ones of the via wirings 82 and 83 is at least the distance L1, and the distance between two adjacent ones of the via wirings 83 is at least the distance L1.

### Structure of Wiring Pattern 62

As illustrated in Fig. 1, for example, the wiring pattern 62 electrically connects the wiring pattern 24 and the electrode 33 of the semiconductor element 30. The wiring pattern 62 extends, for example, from the wiring pattern 24 to the semiconductor element 30 in plan view.

In an example, part of the wiring pattern 62 overlaps the wiring pattern 24 in plan view. The wiring pattern 62 overlaps, for example, a right end portion of the wiring pattern 24 illustrated in Fig. 1 in plan view. The wiring pattern 62 is, for example, electrically connected to the connection member 78 arranged on the wiring pattern 24 by one or more via wirings V2 that extend through the upper substrate 40 in the thickness-wise direction. The wiring pattern 62 is, for example, electrically connected to the wiring pattern 24 through the via wiring V2, the connection member 78, and the joint 77. Although not illustrated in detail, for example, the wiring pattern 62 is formed integrally with the via wiring V2.

In an example, part of the wiring pattern 62 overlaps the semiconductor element 30 in plan view. The wiring pattern 62 overlaps, for example, the electrode 33 of the semiconductor element 30 in plan view. As illustrated in Fig. 3, for example, the wiring pattern 62 is electrically connected to the electrode 33 by one or more via wirings V3 that extend through the upper substrate 40 in the thickness-wise direction. The wiring pattern 62 is, for example, formed integrally with the via wiring V3. The via wiring V3 is, for example, formed in the opening 43 that exposes part of the upper surface of the electrode 33. The opening 43 is, for example, filled with the via wiring V3.

As illustrated in Fig. 1, the wiring pattern 62 is electrically connected to the electrodes 33 through the via wiring V3, and is electrically connected to the wiring pattern 24 through the via wiring V2, the connection member 78, and the joint 77. In other words, the electrode 33, which is a gate electrode, is electrically connected to the wiring pattern 24 through the via wiring V3, the wiring pattern 62, the via wiring V2, the connection member 78, and the joint 77.

### Structure of Encapsulation Resin 50

As illustrated in Fig. 3, for example, the encapsulation resin 50 encapsulates the semiconductor element 30 disposed between the lower substrate 20 and the upper substrate 40. The encapsulation resin 50 encapsulates the connection members 78 and the joints 71, 73, 76, and 77. The encapsulation resin 50 covers, for example, entire side surfaces of the semiconductor element 30, entire side surfaces of the connection members 78, and entire side surfaces of the joints 71, 73, 76, and 77. The encapsulation resin 50 covers, for example, the first ends of the connection terminals 72 and 74. The encapsulation resin 50 covers, for example, an entire upper surface of the wiring layer 21 exposed from the semiconductor element 30, the connection members 78, and the like. The encapsulation resin 50 covers, for example, entire side surfaces of the wiring layer 21. The encapsulation resin 50 covers, for example, an entire upper surface of the lower substrate 20 exposed from the wiring layer 21. The encapsulation resin 50 covers, for example, entire side surfaces of the lower substrate 20. The encapsulation resin 50 covers, for example, an entire lower surface of the lower substrate 20 exposed from the metal layer 25. The encapsulation resin 50 covers, for example, entire side surfaces of the metal layer 25. The encapsulation resin 50 exposes, for example, the entire lower surface of the metal layer 25. The encapsulation resin 50 covers, for example, an entire lower surface of the upper substrate 40 exposed from the semiconductor element 30 and the connection members 78. The encapsulation resin 50 covers, for example, entire side surfaces of the upper substrate 40. The encapsulation resin 50 covers, for example, an entire upper surface of the upper substrate 40 exposed from the wiring layer 60. The encapsulation resin 50 covers, for example, entire side surfaces of the wiring layer 60. The encapsulation resin 50 covers, for example, the entire upper surface of the wiring layer 60.

The material of the encapsulation resin 50 may be, for example, a non-photosensitive insulating resin including a thermosetting resin as a main component. The material of the encapsulation resin 50 may be, for example, an insulating resin, such as an epoxy-based resin, a polyimide-based resin, or the like, or a resin material obtained by mixing the insulating resin with a filler, such as silica, alumina, or the like. The encapsulation resin 50 may be, for example, a mold resin.

In the present embodiment, the electrode 31 is an example of a second electrode, the electrode 32 is an example of a first electrode, the electrode 33 is an example of a third electrode, the X-axis direction is an example of a first direction, and the Y-axis direction is an example of a second direction.

### Advantages of the Present Embodiment

The present embodiment has the following advantages.
(1) The semiconductor device 10 includes the lower substrate 20, the semiconductor element 30, and the upper substrate 40. The semiconductor element 30 is mounted on the upper surface of the lower substrate 20 and includes the electrodes 32. The upper substrate 40 is arranged on the upper surface of the semiconductor element 30. The semiconductor device 10 includes the via wirings 80 and the wiring layer 60. The via wirings 80 extend through the upper substrate 40 in the thickness-wise direction and are connected to the electrodes 32. The wiring layer 60 is arranged on the upper surface of the upper substrate 40 and is electrically connected to the electrodes 32 by the via wirings 80. The via wirings 80 include two or more types of via wirings 81, 82, and 83 differing from one another in planar size. The via wirings 81, 82, and 83 are arranged so that the planar size decreases from the peripheral portion of the semiconductor element 30 toward the central portion of the semiconductor element 30 in plan view.
   With this structure, the via wirings 81 having a relatively large planar size are arranged in the peripheral portion of the semiconductor element 30, and the via wirings 83 having a relatively small planar size are arranged in the central portion of the semiconductor element 30. As a result, the via wirings 81 having a relatively large planar size that is advantageous for ensuring the reliability of electrical connection are located in the peripheral portion of the semiconductor element 30 where the reliability of the electric connection between the via wiring 80 and the electrode 32 is more likely to decrease. That is, the via wirings 81 having a relatively large planar size that limits decreases in the reliability of electrical connection are located in the peripheral portion of the semiconductor element 30 where the reliability of the electric connection is more likely to decrease. This minimizes decreases in the reliability of electrical connection between the via wirings 81 and the electrodes 32 in the peripheral portion of the semiconductor element 30.
(2) The via wirings 83 having a relatively small planar size are arranged in the central portion of the semiconductor element 30 where the reliability of electrical connection between the via wiring 80 and the electrode 32 is less likely to decrease. Such via wirings 83 having a relatively small planar size allow for arrangement of the via wirings 80 on the electrodes 32 even in a relatively small space. Therefore, as compared to when the via wirings 80 only include, for example, the via wirings 81 having the relatively large planar size, a greater number of via wirings 81, 82, and 83 may be arranged on the electrodes 32 while minimizing unused space between adjacent ones of the via wirings 80. This increases the total bonding area between the via wirings 80 and the electrodes 32. As a result, the reliability of the electrical connection between the via wirings 80 and the electrodes 32 improves.
(3) In the via wirings 83 having a relatively small planar size, the reliability of electrical connection with the electrodes 32 is more likely to decrease than in the via wirings 81 having a relatively large planar size. Such via wirings 83 are arranged in the central portion of the semiconductor element 30 where the reliability of electrical connection between the via wirings 80 and the electrodes 32 is less likely to decrease. Thus, even when the via wirings 83 having a relatively small planar size are included, decreases in the reliability of electrical connection between the via wirings 83 and the electrodes 32 are minimized.
(4) The via wirings 80 are arranged next to one another in the X-axis direction that is a planar direction, and in the Y-axis direction that is another planar direction. The via wirings 80 are arranged so that the planar size decreases from the peripheral portion toward the central portion of the semiconductor element 30 in the X-axis direction. This limits decreases in the reliability of electrical connection between the via wirings 80 and the electrodes 32 in the peripheral portion of the semiconductor element 30 in the X-axis direction. The via wirings 80 are arranged so that the planar size decreases from the peripheral portion toward the central portion of the semiconductor element 30 in the Y-axis direction. This limits decreases in the reliability of electrical connection between the via wirings 80 and the electrodes 32 in the peripheral portion of the semiconductor element 30 in the Y-axis direction. In this manner, the above structure minimizes decreases in the reliability of electrical connection between the via wirings 80 and the electrodes 32 in the peripheral portion of the semiconductor element 30 in both the X-axis direction and the Y-axis direction.

### Modified Examples

The above embodiment may be modified as described below. The above embodiment and the following modifications may be combined if the combined modifications remain technically consistent with each other.

The quantity and arrangement of via wirings 80 in the above embodiment may be changed.

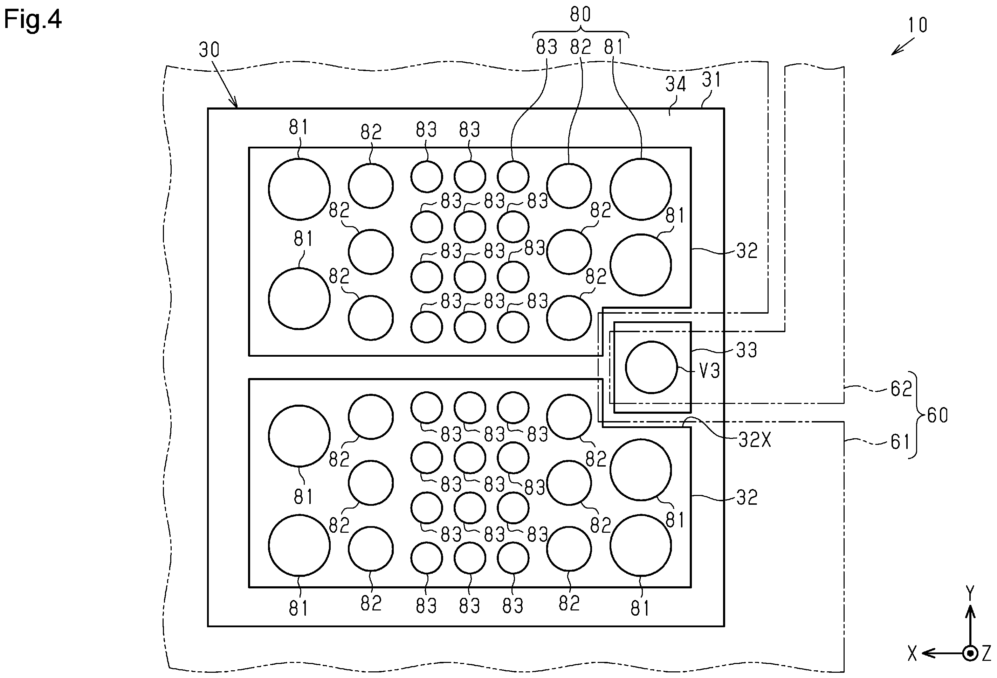

As illustrated in Fig. 4, the via wirings 81, 82, and 83 may be arranged so that the planar size decreases from a peripheral portion toward a central portion of the semiconductor element 30 in the X-axis direction. In this modified example, eight via wirings 81, twelve via wirings 82, and twenty-four via wirings 83 are disposed on the two electrodes 32.

In Fig. 4, the via wirings 83 having the smallest planar size are located in the central portion of the semiconductor element 30 in the X-axis direction. In this modified example, the twenty-four via wirings 83 are arranged in a matrix pattern in a central region of the semiconductor element 30 in the X-axis direction. Each of the two electrodes 32 is provided with twelve of the twenty-four via wirings 83.

The via wirings 82 having the second largest planar size are located closer to the peripheral edges of the semiconductor element 30 than the via wirings 83 are to the peripheral edges of the semiconductor element 30 in the X-axis direction. In this modified example, the twelve via wirings 82 are located at two opposite sides of the twenty-four via wirings 83 in the X-axis direction in plan view. Each of the two electrodes 32 is provided with six of the twelve via wirings 82.

The via wirings 81 having the largest planar size are located closer to the peripheral edges of the semiconductor element 30 than the via wirings 82 are to the peripheral edges of the semiconductor element 30 in the X-axis direction. In this modified example, the eight via wirings 81 are located at two opposite sides of the twelve via wirings 82 in the X-axis direction in plan view. The eight via wirings 81 are arranged along sides of the electrodes 32 that extend in the Y-axis direction. Each of the two electrodes 32 is provided with four of the eight via wirings 81.

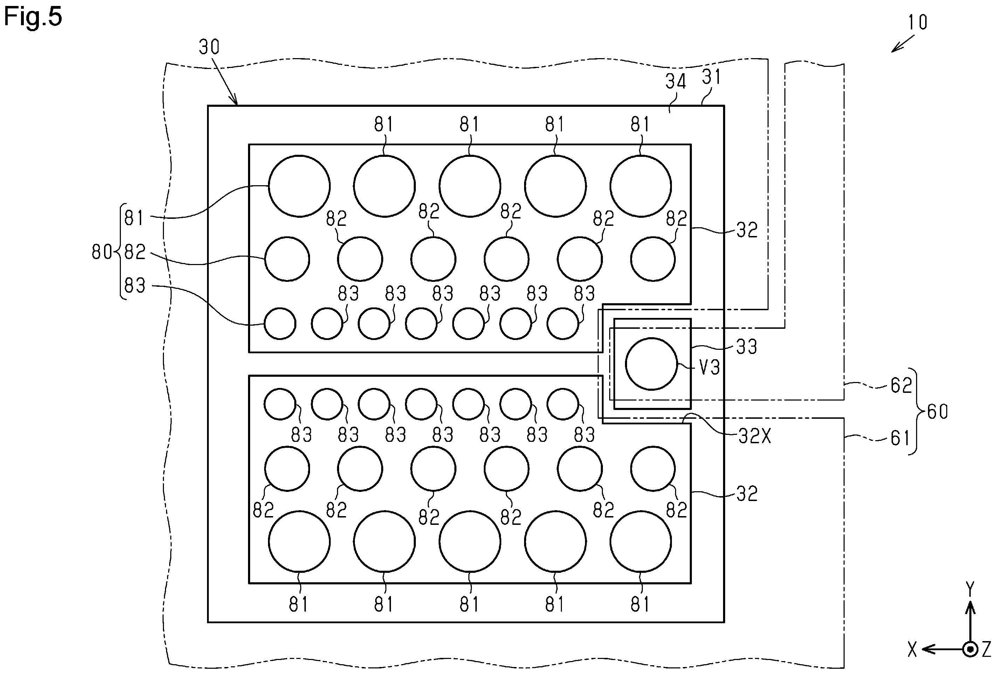

As illustrated in Fig. 5, the via wirings 81, 82, and 83 may be arranged so that the planar size decreases from a peripheral portion toward a central portion of the semiconductor element 30 in the Y-axis direction. In this modified example, ten via wirings 81, twelve via wirings 82, and fourteen via wirings 83 are disposed on the two electrodes 32.

In Fig. 5, the via wirings 83 having the smallest planar size are arranged in the central portion of the semiconductor element 30 in the Y-axis direction. In this modified example, the fourteen via wirings 83 are arranged in a matrix pattern in a central region of the semiconductor element 30 in the Y-axis direction. Each of the two electrodes 32 is provided with seven of the fourteen via wirings 83.

The via wirings 82 having the second largest planar size are located closer to the peripheral edges of the semiconductor element 30 than the via wirings 83 are to the peripheral edges of the semiconductor element 30 in the Y-axis direction. In this modified example, the twelve via wirings 82 are located at two opposite sides of the fourteen via wirings 83 in the Y-axis direction in plan view. Each of the two electrodes 32 is provided with six of the twelve via wirings 82.

The via wirings 81 having the largest planar size are located closer to the peripheral edges of the semiconductor element 30 than the via wirings 82 are to the peripheral edges of the semiconductor element 30 in the Y-axis direction. In this modified example, the ten via wirings 81 are located at two opposite sides of the twelve via wirings 82 in the Y-axis direction in plan view. The ten via wirings 81 are arranged along sides of the electrodes 32 that extend in the X-axis direction. Each of the two electrodes 32 is provided with five of the ten via wirings 81.

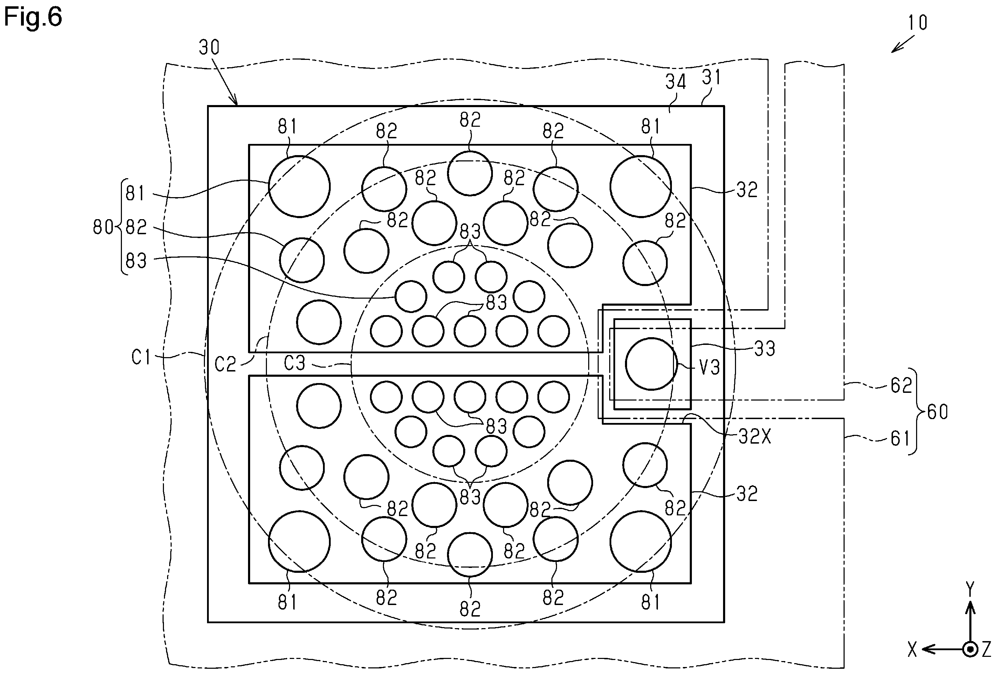

As illustrated in Fig. 6, the via wirings 81, 82, and 83 may be arranged so that the planar size is smallest in a central portion of the semiconductor element 30, and the planar size increases toward a peripheral portion of the semiconductor element 30 in concentric circular shapes in plan view. In this modified example, four via wirings 81, twenty via wirings 82, and eighteen via wirings 83 are disposed on the two electrodes 32. In Fig. 6, three imaginary circles C1, C2, and C3 are indicated by the single-dashed lines. The three imaginary circles C1, C2, and C3 are concentric and share a center that coincides with the planar center of the semiconductor element 30. The imaginary circle C1 has the largest diameter among the imaginary circles C1, C2, and C3. The imaginary circle C2 has a diameter smaller than the imaginary circle C1 and larger than the imaginary circle C3. The imaginary circle C3 has the smallest diameter among the imaginary circles C1, C2, and C3.

The via wirings 83 having the smallest planar size are arranged in the planar central portion of the semiconductor element 30. In this modified example, the eighteen via wirings 83 are located inside the imaginary circle C3 in plan view. Each of the two electrodes 32 is provided with nine of the eighteen via wirings 83.

The via wirings 82 having the second largest planar size are located closer to the peripheral edges of the semiconductor element 30 than the via wirings 83 are. In this modified example, the twenty via wirings 82 surround the eighteen via wirings 83 in plan view. For example, in plan view, the twenty via wirings 82 are located outside the imaginary circle C3, and inside the imaginary circle C1 or on the imaginary circle C2. Although only one imaginary circle C2 is illustrated in Fig. 6 to simplify illustration, there may be multiple imaginary circles C2 between the imaginary circle C3 and the imaginary circle C1. Each of the two electrodes 32 is provided with ten of the twenty via wirings 82.

The via wirings 81 having the largest planar size are located closer to the peripheral edges of the semiconductor element 30 than the via wirings 82 are. In this modified example, the four via wirings 81 are located on the imaginary circle C1 in plan view. The four via wirings 81 are respectively located at the four corners of the semiconductor element 30 in plan view. Each of the two electrodes 32 is provided with two of the four via wirings 81.

In the above embodiment, multiple via wirings 80 include three types of via wirings 81, 82, and 83 having different planar sizes. However, the via wirings 80 are not limited to three types of planar sizes. For example, the via wirings 80 may include two or four or more types of planar sizes.

In the above embodiment, the current input terminal 22A is arranged on the upper surface of the lower substrate 20. However, the position of the current input terminal 22A is not particularly limited. For example, the current input terminal 22A may be disposed on the upper surface of the upper substrate 40.

In the above embodiment, the current output terminal 23A is arranged on the upper surface of the lower substrate 20. However, the position of the current output terminal 23A is not particularly limited. For example, the current output terminal 23A may be disposed on the upper surface of the upper substrate 40. For example, the wiring pattern 61 disposed on the upper surface of the upper substrate 40 may include the current output terminal 23A.

In the above embodiment, the connection terminal 24A is arranged on the upper surface of the lower substrate 20. However, the position of the connection terminal 24A is not particularly limited. For example, the connection terminal 24A may be disposed on the upper surface of the upper substrate 40. For example, the wiring pattern 62 disposed on the upper surface of the upper substrate 40 may include the connection terminal 24A.

The connection terminal 72 of the above embodiment may be omitted.

The connection terminal 74 of the above embodiment may be omitted.

The connection terminal 75 of the above embodiment may be omitted.

The range in which the encapsulation resin 50 is formed in the above embodiment may be changed. For example, the side surfaces of the lower substrate 20 may be exposed from the encapsulation resin 50. For example, the upper surface of the wiring layer 60 may be exposed from the encapsulation resin 50.

The encapsulation resin 50 of the above embodiment may be omitted.

In the above embodiment, the upper substrate 40 has a smaller planar shape than the lower substrate 20. However, the upper substrate 40 may have a larger planar shape than the lower substrate 20 or the same planar shape as the lower substrate 20.

The metal layer 25 of the above embodiment may be omitted.

In the above embodiment, the substrate body 41 of the upper substrate 40 has a single-layer structure. Instead, the substrate body 41 may have, for example, a stack structure in which one or more wiring layers and multiple insulating layers are stacked.

In the above embodiment, the semiconductor element 30 is a MOSFET. However, there is no limitation to such a configuration.

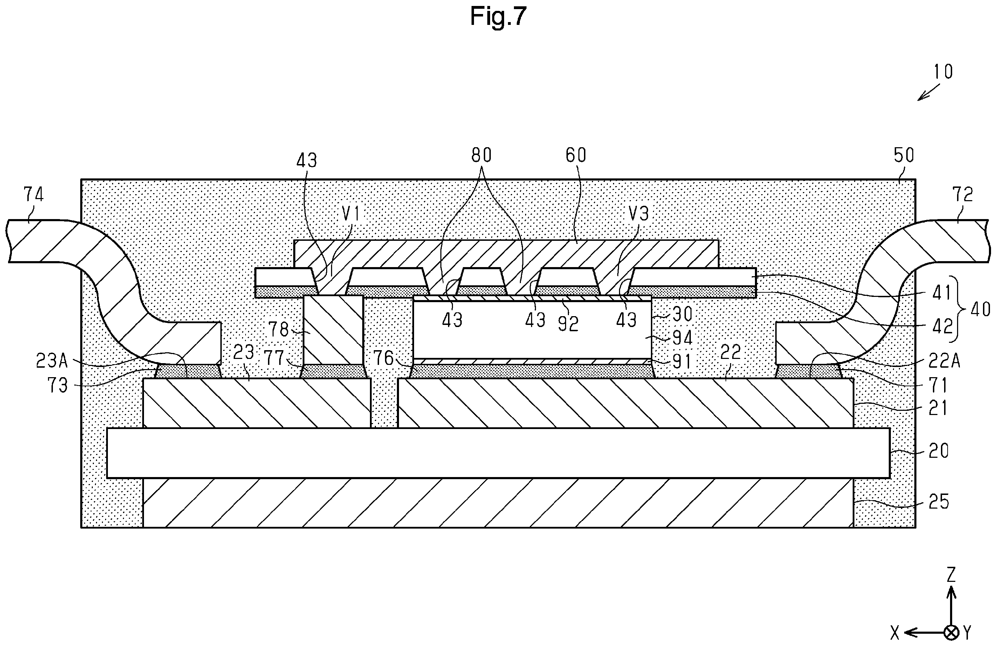

As illustrated in Fig. 7, for example, the semiconductor element 30 may be a diode having an electrode 91 that serves as an anode electrode, and an electrode 92 that serves as a cathode electrode. The semiconductor element 30 includes, for example, a body portion 94. The electrode 91 is, for example, arranged on a lower surface of the body portion 94. The electrode 91 covers, for example, the entire lower surface of the body portion 94. The electrode 92 is, for example, arranged on an upper surface of the body portion 94. The electrode 92 covers, for example, the entire upper surface of the body portion 94. In this case, the wiring layer 60 is electrically connected to the electrode 92 through the multiple via wirings 80 that extend through the upper substrate 40 in the thickness-wise direction. Even in this case, the via wirings 80 are arranged so that the planar size decreases from the peripheral portion toward the central portion of the semiconductor element 30 in plan view.

In the above embodiment, the semiconductor device 10 is a power semiconductor device. However, there is no limitation to such a configuration. The semiconductor device 10 may be, for example, any type of various semiconductor devices other than the power semiconductor device.

In the above embodiment, the semiconductor element 30 is a power semiconductor element. However, there is no limitation to such a configuration. The semiconductor element 30 may be, for example, any type of various semiconductor elements other than the power semiconductor element.

Various changes in form and details may be made to the examples above without departing from the spirit and scope of the claims and their equivalents. The examples are for the sake of description only, and not for purposes of limitation. Descriptions of features in each example are to be considered as being applicable to similar features or aspects in other examples. Suitable results may be achieved if sequences are performed in a different order, and/or if components in a described system, architecture, device, or circuit are combined differently, and/or replaced or supplemented by other components or their equivalents. The scope of the disclosure is not defined by the detailed description, but by the claims and their equivalents. All variations within the scope of the claims and their equivalents are included in the disclosure.

## Claims

1. A semiconductor device (10), comprising:
a lower substrate (20);
a semiconductor element (30) mounted on an upper surface of the lower substrate (20) and including a first electrode (32;92) arranged on an upper surface of the semiconductor element (30);
an upper substrate (40) arranged on the upper surface of the semiconductor element (30);
via wirings (80) extending through the upper substrate (40) in a thickness-wise direction and connected to the first electrode (32;92); and
a wiring layer (60) arranged an upper surface of the upper substrate (40) and electrically connected to the first electrode (32;92) by the via wirings (80), wherein
the via wirings (80) include two or more types of via wirings (80:81,82,83) differing from one another in planar size, and
the via wirings (80:81,82,83) are arranged so that the planar size decreases from a peripheral portion of the semiconductor element (30) toward a central portion of the semiconductor element (30) in plan view.

2. The semiconductor device (10) according to claim 1, wherein
the via wirings (80:81,82,83) are arranged next to one another in a first direction in plan view, and
the via wirings (80:81,82,83) are arranged so that the planar size decreases from the peripheral portion toward the central portion in the first direction.

3. The semiconductor device (10) according to claim 2, wherein
the via wirings (80:81,82,83) are arranged next to one another in a second direction orthogonal to the first direction in plan view, and
the via wirings (80:81,82,83) are arranged so that the planar size decreases from the peripheral portion toward the central portion in the second direction.

4. The semiconductor device (10) according to claim 3, wherein
the semiconductor element (30) has a rectangular planar shape, and
the via wirings (80:81,82,83) are arranged so that the planar size is smallest at the center portion and the planar size increases from the center portion toward the peripheral portion in concentric rectangular shapes in plan view.

5. The semiconductor device (10) according to claim 1, wherein
the semiconductor element (30) has a rectangular planar shape, and
the via wirings (80:81,82,83) are arranged so that the planar size is smallest at the center portion and the planar size increases from the center portion toward the peripheral portion in concentric circular shapes in plan view.

6. The semiconductor device (10) according to any one of claims 1 to 5, further comprising an encapsulation resin (50) arranged between the lower substrate (20) and the upper substrate (40) and encapsulating the semiconductor element (30).

7. The semiconductor device (10) according to any one of claims 1 to 6, wherein the semiconductor element (30) includes a power semiconductor element (30).

8. The semiconductor device (10) according to claim 7, wherein the semiconductor element (30) includes a metal-oxide-semiconductor field-effect transistor that has the first electrode (32) serving as a source electrode, a second electrode (31) serving as a drain electrode, and a third electrode (33) serving as a gate electrode.

9. The semiconductor device (10) according to claim 7, wherein the semiconductor element (30) includes a diode that has the first electrode (92) serving as a cathode electrode, and a second electrode (91) serving as an anode electrode.
